# FASCICULE DE BREVET EUROPEEN

(11) **EP 0 322 303 B1**
(45) Date de publication et mention de la délivrance du brevet: **24.03.1993**
(21) Numéro de dépôt: 88403249.1
(22) Date de dépôt: 20.12.1988
(51) Int. Cl.: H01L 29/78

(54) **Dispositif de transfert de charges à abaissement de potentiel de transfert en sortie, et procédé de fabrication de ce dispositif**
Ladungsverschiebeanordnung mit Senkung der Ausgangsverschiebespannung und Verfahren zu ihrer Herstellung
Charge transfer device using lowering of the output transfer voltage, and method for making the same

(30) Priorité: 22.12.1987 FR 8717880
(43) Date de publication de la demande: 28.06.1989
(73) Titulaire: THOMSON-CSF, 75008 Paris (FR)
(72) Inventeur: Cazaux, Yvon, F-92402 COURBEVOIE CEDEX (FR); Thenoz, Yves, F-92402 COURBEVOIE CEDEX (FR); Herault, Didier, F-92402 COURBEVOIE CEDEX (FR); Blanchard, Pierre, F-92402 COURBEVOIE CEDEX (FR)
(74) Mandataire: Guérin, Michel

(56) Documents cités:
- EP-A- 0 192 142
- FR-A- 2 227 646
- US-A- 3 796 932

## Description

La présente invention concerne un dispositif de transfert de charges à abaissement de potentiel de transfert en sortie, ainsi qu'un procédé de fabrication de ce dispositif.

Elle s'applique à la réalisation de mémoires, de registres à décalage, de lignes à retard, aux caméras de télévisions, etc.

Les dispositifs à transfert de charges (en anglais "charges coupled devices", ou en abrégé CCD) sont des systèmes à semi-conducteurs dans lesquels on stocke des charges dans des puits de potentiel. Ces charges sont créées à la surface d'une couche semi-conductrice, généralement formée sur un substrat, ou à l'interface entre la couche semi-conductrice et une couche superficielle isolante (dispositif dit à "canal enterré"). Les charges sont transférées d'une position amont vers une position aval, en occupant successivement, grâce à des potentiels de transferts, tous les puits de potentiel créés entre ces deux positions. D'une façon générale, ces dispositifs comprennent, très schématiquement, un substrat semiconducteur dopé d'un certain type, une couche d'un matériau isolant, et un ensemble d'électrodes sur cette couche isolante portée à des potentiels appropriés. Cet isolant peut être un oxyde. Les charges déplacées dans de tels dispositifs sont des électrons.

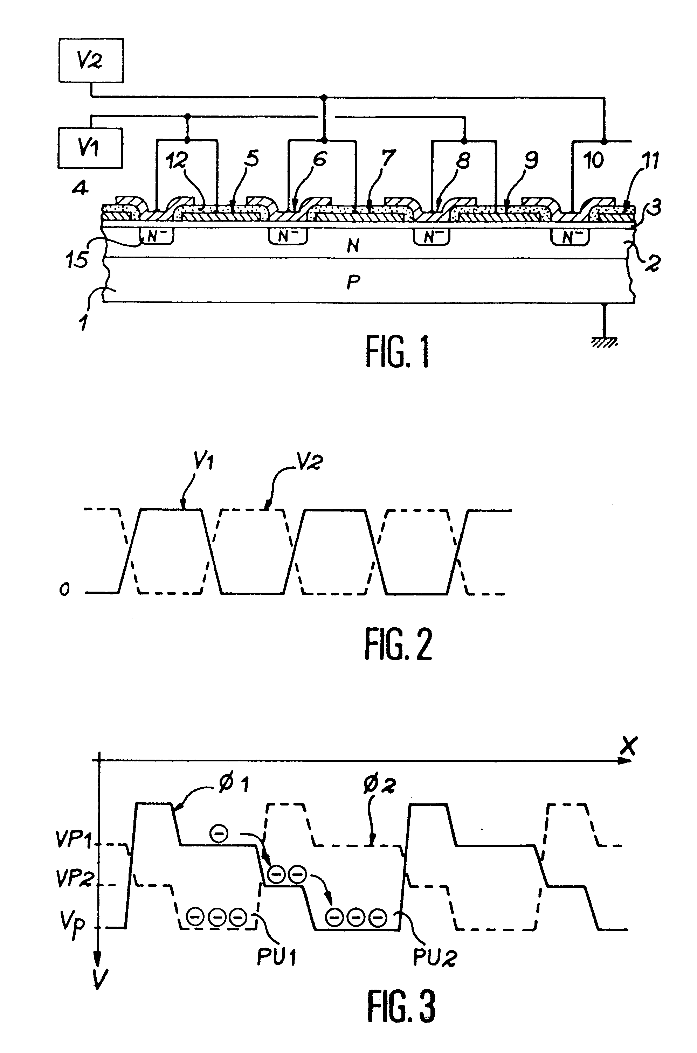

Un autre dispositif de transfert de charges de type connu, et plus performant que les précédents, est représenté schématiquement et en coupe sur la figure 1. Ce dispositif comprend, sur un substrat semi-conducteur dopé d'un premier type (de type P par exemple), une couche semi-conductrice 2 dopée d'un deuxième type (de type N) d'une première concentration. Une couche isolante 3 (un oxyde par exemple), recouvre la couche semi-conductrice 2. Ce dispositif comporte aussi le long d'un axe orienté X, définissant un sens de circulation des charges, entre une position amont ou les charges sont créées, et une position aval, au moins une première paire d'électrodes 4, 5 et au moins une deuxième paire d'électrodes 6, 7. On a également représenté sur cette figure, d'autres paires d'électrodes 8, 9 et 10, 11 identiques aux paires d'électrodes précédentes. Les charges sont créées du côté de la position amont (en amont de l'électrode 4), par des moyens connus dans l'état de la technique et qui ne sont donc pas représentés.

Chaque paire d'électrodes telle que 4, 5 comprend, dans le sens de circulation X, une électrode de transfert 4, et une électrode de stockage 5 des charges. Ces électrodes sont en contact avec la couche isolante 3 et les électrodes de stockage telles que l'électrode 5, sont recouvertes d'un revêtement électriquement isolant 12 (un oxyde par exemple).

Ce dispositif connu dans l'état de la technique comprend aussi des moyens, qui en combinaison avec des potentiels électriques appliqués aux électrodes, permettent de créer des puits de potentiel de profondeurs égales, en regard des électrodes de stockage 5, 7, 9 et des potentiels de transfert dissymétriques identiques en regard des électrodes de transfert 4, 6, 8... et des électrodes de stockage 5, 7, 9,... Ces potentiels de transfert et ces puits de potentiel permettent, de manière connue, de faire circuler les charges dans le sens X choisi. Ils apparaissent à l'interface entre la couche semi-conductrice 2 et la couche isolante 3. De façon connue, les moyens qui permettent de créer ces puits de potentiel et ces potentiels de transfert, comportent des zones dopées du second type avec une seconde concentration (de type N⁻ dans l'exemple considéré) qui sont réalisées dans la couche semi-conductrice 2 de deuxième type, en regard des électrodes de transfert 4, 6, 8... etc. Ces moyens comprennent aussi deux sources électriques de tensions V1, V2. La source de tension V1 est reliée aux paires d'électrodes 4-12, 8-9, tandis que la source de tension V2 est reliée aux paires d'électrodes 6-7, 10-11.

Les tensions V1, V2 varient cycliquement entre des valeurs identiques et en opposition de phase, tel que représenté sur la figure 2 (par exemple entre la valeur 0 et une valeur positive).

Dans ce type de dispositif, les potentiels appliqués aux paires d'électrodes successives ayant les mêmes valeurs extrêmes et la couche semi-conductrice 2 dopée d'un deuxième type d'une première concentration (N par exemple) présentant des zones identiques 15 dopées d'un deuxième type (N⁻ par exemple) d'une seconde concentration, les puits de potentiel en regard des électrodes de stockage ont la même profondeur, tout au long du parcours des charges dans le dispositif. Les potentiels de transfert présentent également des variations de niveaux identiques tout au long du parcours.

Le figure 3 permet de mieux comprendre le fonctionnement de ce dispositif connu. Cette figure représente le profil de potentiel V, le long du dispositif de la figure 1, dans le sens de circulation X. Ce potentiel est celui qui apparaît à l'interface entre la couche semi-conductrice 2 et la couche isolante 3, lorsque les tensions V1, V2, en position de phases, sont appliquées aux paires d'électrodes, comme indiqué plus haut. Sur cette figure le diagramme Φ 1 correspond au potentiel de surface apparaissant sous les électrodes lorsque la tension V1 est appliquée aux électrodes correspondantes, tandis que le diagramme Φ 2 représente le potentiel de surface lorsque la tension V2 est appliquée aux électrodes correspondantes. Ce potentiel de surface dépend de la densité du dopant en tous points de la verticale du point de la surface considérée. Il dépend également des potentiels appliqués aux électrodes. Le présence de la couche dopée de deuxième type d'une première concentration (N dans l'exemple considéré), sous les électrodes 5, 7, 9 provoque une augmentation de la profondeur du puits de potentiel dans cette région. Au contraire, sous les électrodes de transfert pour lesquelles existe une zone dopée du second type d'une seconde concentration (N⁻ dans l'exemple considéré), le puits de potentiel est moins important. Il en résulte qu'en faisant varier les potentiels appliqués aux électrodes, on crée dans l'intervalle entre ces électrodes un puits de potentiel asymétrique qui est plus profond en aval qu'en amont. Lorsque la tension V1 ou V2 appliquée aux électrodes de stockage 5, 7, 9 etc... est maximale, la profondeur des puits de potentiel PU1, PU2, ..., créés sous les électrodes, est elle-même maximale, et égale à VP par exemple. Les électrons sont alors stockés dans ces puits de potentiel tels que représentés sur la figure 3. Au contraire, lorsque la tension appliquée à l'électrode de stockage et à l'électrode de transfert correspondantes diminue, la profondeur du puits de potentiel diminue et les électrons qui étaient stockés dans le puits de potentiel PU1, sont transférés dans le puits de potentiel PU2 sous l'électrode de stockage suivante. Les paliers de potentiels tels que VP1, VP2 favorisent ce transfert.

Un tel dispositif à transfert de charge, comportant des paires d'électrodes du type présentant des différences de dopage sous les électrodes d'une même paire, est décrit notamment dans un document de brevet européen EP-A-0192142. Ce document décrit en outre comment améliorer le bruit en lecture, notamment en reliant une électrode de sortie au potentiel du substrat.

Il peut être parfois utile et notamment, comme on le verra plus loin en détail, dans un dispositif de lecture de charge situé en aval, à l'extrémité ou sortie du dispositif, d'abaisser les valeurs des potentiels de transfert à cette extrémité aval du dispositif.

Aucun dispositif ne permet actuellement de façon simple, de diminuer les valeurs des paliers des potentiels de transfert, à une extrémité aval d'un dispositif de transfert de charges. Il en résulte que les amplificateurs de lecture qui sont reliés aux extrémités aval des dispositifs à transfert de charges connus, de type décrit plus haut, ont une tension d'alimentation parfois bien supérieure aux tensions électriques d'alimentation des ensembles dans lesquels ces dispositifs à transfert de charges sont utilisés.

L'invention a pour but de remédier à ces inconvénients et notamment de réaliser un dispositif à transfert de charges dans lequel il est possible de créer, à partir d'une position aval, le long de l'axe de circulation des charges, à l'interface de la couche semi-conductrice et de la couche isolante, des paliers de potentiels de transfert, de valeurs moins importantes que celles des paliers de potentiels apparaissant entre les positions amont et aval, notamment pour pouvoir abaisser de façon notable la valeur de la tension d'alimentation de l'amplificateur de lecture situé à une extrémité du dispositif, au-delà de la position aval. L'invention a aussi pour but de fournir un procédé de fabrication très simple d'un tel dispositif.

L'invention a pour objet un dispositif de transfert de charges comportant un substrat semi-conducteur dopé d'un premier type, une couche semi-conductrice dopée d'un deuxième type d'une première concentration recouvrant ce substrat, une couche isolante recouvrant cette couche semi-conductrice et, le long d'un même axe définissant un sens de circulation des charges entre une position amont et une position aval, au moins une première et une deuxième paires d'électrodes comportant chacune, dans ledit sens, une électrode de transfert et une électrode de stockage présentant des surfaces de contact avec la couche isolante, des zones dopées du deuxième type d'une seconde concentration étant réalisées en regard des surfaces de contact des électrodes de transfert des première et deuxième paires, dans la couche semi-conductrice de deuxième type, les électrodes des première et deuxième paires étant respectivement reliées à une première et une deuxième sources de tension variant cycliquement et en opposition de phases, entre une première et une deuxième valeurs, créant des puits de potentiel de profondeurs égales en regard des électrodes de stockage, et des potentiels de transfert identiques et déphasés, en regard des électrodes de transfert et de stockage des première et deuxième paires, pour faire circuler les charges dans ledit sens, caractérisé en ce qu'il comporte, à partir de la position aval, le long dudit axe, dans le sens de circulation, une couche semi-conductrice dopée du deuxième type d'une troisième concentration réalisée dans la couche de deuxième type, au moins une troisième paire d'électrodes comportant, dans ledit sens, une électrode de transfert et une électrode de stockage présentant des surfaces de contact avec la couche isolant, et des moyens créant en regard des électrodes de la troisième paire, des potentiels de transfert de valeurs inférieures à celles des potentiels de transfert en regard des électrodes de transfert et de stockage des première et deuxième paires.

Les moyens qui permettent de créer, à partir d'une position aval, des potentiels de transfert inférieurs aux potentiels apparaissant entre les positions amont et aval, peuvent être assimilés à un système hydraulique d'écluse puisque historiquement, les puits de potentiel sont comparés à des seaux successifs pour lesquels le liquide contenu dans l'un des seaux est transféré successivement d'un seau à un autre.

Selon une autre caractéristique de l'invention, les moyens pour créer en regard des électrodes de la troisième paire, des potentiels de transfert inférieurs à ceux des première et deuxième paires, comportent une zone dopée du deuxième type et d'une troisième concentration en regard de l'électrode de transfert de la troisième paire, dans la couche semi-conductrice dopée du deuxième type avec la seconde concentration, les électrodes de transfert et de stockage de la troisième paire étant reliées à une source de tension variant cycliquement et en phase avec la tension appliquée aux électrodes de la première paire, cette tension variant entre ladite première valeur et une troisième valeur supérieure à la deuxième valeur.

Selon une autre caractéristique de l'invention, le substrat semi-conducteur dopé d'un premier type, est de type P, la couche semi-conductrice dopée de deuxième type d'une première concentration est de type N, la couche semi-conductrice et les zones semi-conductrices dopées du deuxième type avec la deuxième concentration sont de type N⁻, présentant un dopage moins important que la couche semi-conductrice dopée du deuxième type N⁻ et de la première concentration, la zone semi-conductrice dopée du deuxième type et de la troisième concentration étant de type N⁻⁻, présentant un dopage moins important que la couche semi-conductrice dopée de deuxième type N⁻ avec la deuxième concentration.

Selon une autre caractéristique le dispositif comporte en outre des moyens pour détecter les charges accumulées sous l'électrode de stockage de la troisième paire, ces moyens comprenant une électrode intermédiaire adjacente à l'électrode de stockage de la troisième paire et en contact avec la couche isolante, et une électrode de commande espacée de l'électrode intermédiaire, en contact avec la couche isolante, une zone semi-conductrice dopée du deuxième type et d'une quatrième concentration réalisée dans la couche semi-conductrice dopée du deuxième type d'une deuxième concentration dans une zone en regard de l'espace situé entre l'électrode intermédiaire et l'électrode de commande et une deuxième zone semi-conductrice dopée du deuxième type et de la quatrième concentration, réalisée dans la couche semi-conductrice dopée de second type et de seconde concentration, dans une zone adjacente à l'électrode de commande, dans le sens de circulation, l'électrode de commande, la deuxième zone et l'électrode intermédiaire étant respectivement reliées à des sources pour créer un puits de potentiel en regard de la première zone de profondeur moins importante que celle du puits de potentiel sous les électrodes de stockage des première et deuxième paires, la première zone étant reliée à un amplificateur de mesure des charges accumulées dans le puits de potentiel en regard de cette première zone.

Selon une autre caractéristique, les zones semi-conductrices dopées de cinquième type, sont de type N⁺, présentant un dopage plus important que la couche semi-conductrice dopée de deuxième type N.

L'invention vise aussi un procédé de fabrication d'un dispositif à transfert de charges, consistant à former sur un substrat semi-conducteur dopé d'un premier type, une couche semi-conductrice dopée d'un deuxième type d'une première concentation, à recouvrir cette couche semi-conductrice d'une couche isolante, à former sur cette couche isolante une succession d'électrodes faites de silicium polycristallin recouvertes d'un isolant, ces électrodes étant espacées le long d'un axe, puis à réaliser dans la couche semi-conductrice de deuxième type, entre les électrodes de ladite succession, des zones dopées du second type avec une seconde concentration, une zone dopée du second type et de la seconde concentration s'étendant aussi au-delà de la dernière électrode de la succession, le long dudit axe, caractérisé en ce qu'il consiste en outre à former sur la couche isolante, au moins une électrode supplémentaire de silicium polycristallin recouverte d'un isolante, espacée de la dernière électrode de ladite succession, le long dudit axe, puis à réaliser une zone dopée du deuxième type, et d'une troisième concentration entre la dernière électrode de la succession et l'électrode supplémentaire, dans la zone dopée de deuxième type et de deuxième concentration, puis on réalise une série d'électrodes de silicium polycristallin situées respectivement en regard des zones dopées de deuxième type de deuxième et troisième concentration, ces électrodes étant en contact avec la couche isolante et recouvrant respectivement et partiellement les électrodes de ladite succession et l'électrode supplémentaire.

Selon une autre caractéristique de ce procédé, celui-ci consiste en outre à former sur la couche isolante une électrode de commande faite d'un silicium polycristallin espacée de la dernière électrode de ladite série qui recouvre partiellement ladite électrode supplémentaire, le long dudit axe, puis à réaliser une première et une deuxième zones dopées du deuxième type avec une quatrième concentration, dans la zone semi-conductrice du deuxième type et deuxième concentration, de part et d'autre de l'électrode de commande.

Les caractéristiques et les avantages de l'invention ressortiront mieux à la description qui va suivre donnée en référence aux figures annexées dans lesquelles :
- les figures 1, 2, 3 ont déjà été décrites et permettent de mieux comprendre la structure et le fonctionnement d'un dispositif connu dans l'état de la technique,
- la figure 4 représente schématiquement et en coupe, un dispositif de transfert de charges conforme à l'invention, ce dispositif comportant des moyens permettant de créer des potentiels de transfert et des puits de potentiel moins importants à partir d'une position aval,
- la figure 5 est un diagramme des tensions qui sont appliquées aux différentes électrodes du dispositif de la figure 4,
- la figure 6 est un diagramme représentant les potentiels de transfert et les puits de potentiel le long d'un axe X de circulation des charges, à l'interface entre la couche semi-conductrice et la couche isolante, dans le dispositif de la figure 4,
- la figure 7 représente schématiquement et en coupe, un dispositif de transfert de charges conformes à l'invention comportant, à partir d'une extrémité aval, des moyens pour détecter et mesurer les charges accumulées à cette extrémité,
- la figure 8 est un diagramme des tensions appliquées aux principales électrodes du dispositif de la figure 7,
- la figure 9 est un diagramme représentant les potentiels essentiels apparaissant à l'interface entre la couche semi-conductrice et la couche isolante dans le dispositif de la figure 7,
- les figures 10 à 15 représentent schématiquement les étapes essentielles d'un procédé de fabrication du dispositif conforme à l'invention, pour un premier mode de mise en oeuvre de ce procédé,
- les figures 16 à 18 représentent certaines des étapes de fabrication du dispositif conforme à l'invention, pour un autre mode de mise en oeuvre de ce procédé de fabrication.

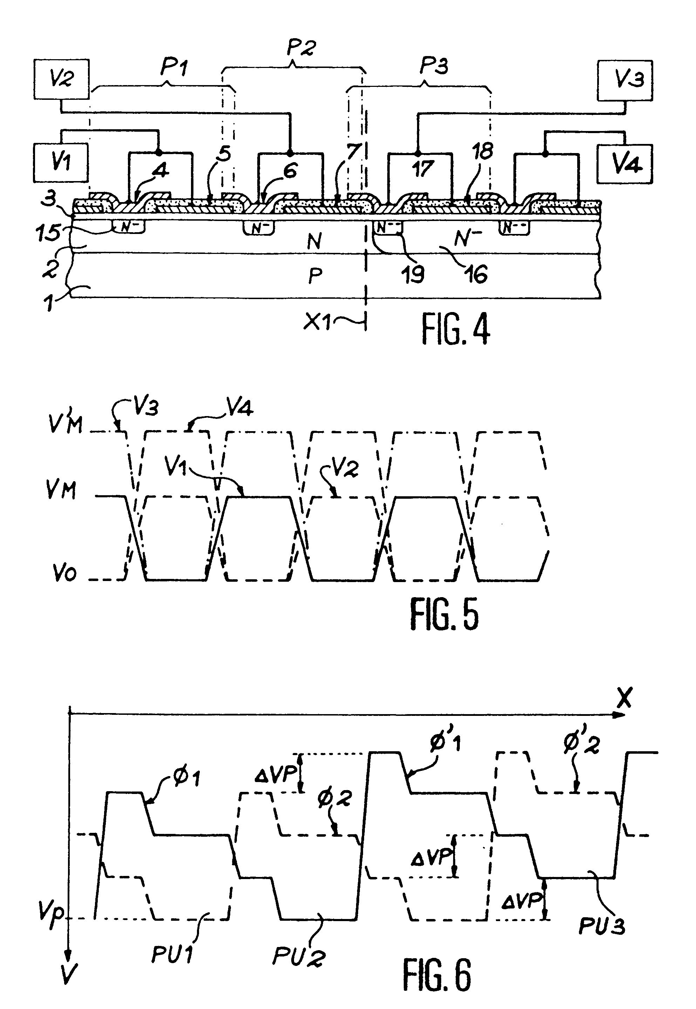

Le dispositif de transfert de charges représenté schématiquement et en coupe sur la figure 4 comprend un substrat semi-conducteur 1 dopé d'un premier type, une couche semi-conductrice 2 dopée d'un deuxième type d'une première concentration recouvrant le substrat et une couche isolante 3 recouvrant cette couche semi-conductrice. Ce dispositif comprend aussi, le long d'un même axe X définissant un sens de circulation des charges, entre une position amont où des charges sont créées, et une position aval où elle doivent être détectées, au moins une première et une deuxième paires d'électrodes P1, P2 comportant chacune, dans le sens de circulation X, une électrode de transfert et une électrode de stockage. Les électrodes de transfert sont représentées en 4, 6, tandis que les électrodes de stockage sont représentées en 5, 7, Chacune de ces électrodes présente une surface de contact avec la couche isolante 3. Le dispositif comprend aussi comme les dispositifs connus, des moyens pour créer des puits de potentiel PU1, PU2, de profondeurs égales en regard des électrodes de stockage et des potentiels de transfert identiques en regard des potentiels de transfert et de stockage, pour faire circuler les charges dans le sens X choisi.

Selon l'invention le dispositif comporte, à partir d'une position aval X1, le long de l'axe X, dans le sens de circulation, au-delà de l'électrode de stockage 7, une couche semi-conductrice 16 dopée du second type et d'une seconde concentration, réalisée à partir de la couche semi-conductrice 2 de deuxième type d'une première concentration, ainsi qu'au moins une troisième paire d'électrodes P3. Cette troisième paire d'électrodes comporte dans le sens de circulation, une électrode de transfert 17 et une électrode de stockage 18, qui présentent des surfaces de contact avec la couche isolante 3. Le dispositif peut aussi comporter d'autres paires d'électrodes identiques à la troisième paire P3. Ces électrodes sont représentées sur la figure mais ne sont pas référencées. Le dispositif comporte aussi des moyens qui seront décrits plus loin et qui permettent de créer des potentiels de transfert, en regard des électrodes de transfert et de stockage 17, 18 de la troisième paire, qui présentent, comme on le verra plus loin en détail, des paliers de valeurs inférieures à des paliers existant en regard des électrodes de transfert et de stockage des première et deuxième paires.

Les moyens qui permettent de créer les puits de potentiel PU1, PU2, de profondeurs égales en regard des électrodes de stockage 5, 7 des première et deuxième paires d'électrodes P1, P2 et des potentiels de transfert présentant des paliers correspondants de valeurs identiques en regard des électrodes de transfert et de stockage de ces première et deuxième paires, comportent comme sur la figure 1, des zones dopées 15 du second type et de la seconde concentration, réalisées dans la couche semi-conductrice 2 de deuxième type de première concentration. Ces zones du second type d'une seconde concentration sont réalisées en regard des surfaces de contact des électrodes de transfert 4, 6 des première et deuxième paires P1 et P2. Ces moyens comportent aussi une première et une deuxième sources de tension V1, V2, reliées respectivement aux électrodes 4, 5 de la première paire, et aux électrodes 6, 7 de la deuxième paire. Ces tensions, comme représenté sur le diagramme de la figure 5, varient cycliquement et en opposition de phases, entre une première valeur V0 qui peut être le potentiel de la masse par exemple, et une deuxième valeur V1 maximale (positive dans le mode de réalisation décrit).

Les moyens qui permettent de créer en regard des électrodes de la troisième paire, des potentiels de transfert présentant des paliers de valeurs inférieures à celles des potentiels de transfert en regard des électrodes des première et deuxième paries, comportent une zone dopée 19 du second type et d'une troisième concentration, en regard de l'électrode de stockage 17 de la troisième paire P3. Cette zone dopée du second type d'une troisième concentration est réalisée dans la couche semi-conductrice 16 dopée du second type seconde concentration. Ces moyens comportent aussi une source de tension V3 reliée aux électrodes 17, 18 de la troisième paire. Cette tension varie cycliquement et en phase avec la tension V1 appliquée aux électrodes 4, 5 de la première paire, tel que représenté sur le diagramme de la figure 5. La tension V3 varie cycliquement entre la première valeur minimale VO des tensions appliquées aux électrodes des première et deuxième paires, et une troisième valeur V3 supérieure à la deuxième valeur VM des tensions V1 et V2.

On a également représenté sur cette figure, une source de tension V4 qui pourrait alimenter d'autres électrodes identiques à celles de la troisième paire. Cette source de tension fournit une tension cyclique V4, en opposition de phase avec la tension V3, et présentant les mêmes valeurs extrêmes que celles-ci, tel que représenté sur le diagramme de la figure 5.

Les diagrammes Φ1, Φ2 de la figure 6 représentent les potentiels de transfert et les puits de potentiel PU1, PU2 de profondeur VP, créés à l'interface entre la couche semi-conductrice 2 et la couche isolante 3, sous les premières paires d'électrodes P1 et P2. Ces puits et potentiels de transfert sont identiques à ceux de la figure 3, pour les deux premières paires d'électrodes P1, P2.

Les diagrammes Φ'1 et Φ'2 représentent les potentiels de transfert et les puits de potentiel créés à l'interface entre la couche semi-conductrice 16 du second type et de deuxième concentration et la couche isolante 3, lorsque les tensions cycliques V3 et V4 sont appliquées respectivement à la troisième paire d'électrodes P3 et aux paires d'électrodes suivantes, dans le sens de circulation des charges. Les tensions V3, V4 varient cycliquement entre la première valeur V0 des tensions V1 et V2 et la valeur V'M supérieure à la tension VM. On voit sur les diagrammes Φ'1, Φ'2 que le puits de potentiel apparaissant sous l'électrode de stockage de la troisième paire et des paires suivantes ont une profondeur moins importante que les puits de potentiel sous les électrodes de stockage des première et deuxième paires d'électrodes. Les potentiels de transfert présentent eux aussi des paliers de valeurs moins importantes que pour les première et deuxième paires. En fait, le dopage moins important de la couche semi-conductrice 16 que celui de la couche semi-conductrice 2, et le dopage moins important des zones 19 sous l'électrode de transfert telles que 17 permettent d'abaisser les valeurs des paliers de potentiels de transfert et aussi de diminuer la profondeur des puits de potentiel d'une quantité de valeur ΔVP. L'écluse mentionnée plus haut est donc réalisée à partir de la position aval X1. C'est précisément la diminution des valeurs des potentiels de transfert qui est intéressante, comme on le verra plus loin en détail.

Dans un mode de réalisation préférentiel du dispositif de l'invention, le substrat semi-conducteur 1 dopé d'un premier type est de type P. Les couche semi-conductrice 2 dopée de deuxième type d'une première concentration, est de type N. La couche semi-conductrice 16, ainsi que les zones 15 dopées de deuxième type et d'une deuxième concentration, sont de type N⁻. Les zones 15 présentent en fait un dopage moins important que la couche semi-conductrice 2, de type N. Les zones semi-conductrices dopées du second type avec la troisième concentration, telles que la zone 19 sous l'électrode de transfert 17, sont des zones de type N⁻⁻, présentant un dopage moins important que la couche semi-conductrice dopée 16 de type N⁻. Les quantités de dopant pour les zones 15 de type N⁻ et la couche 16, de type N⁻ peuvent être égales ou différentes.

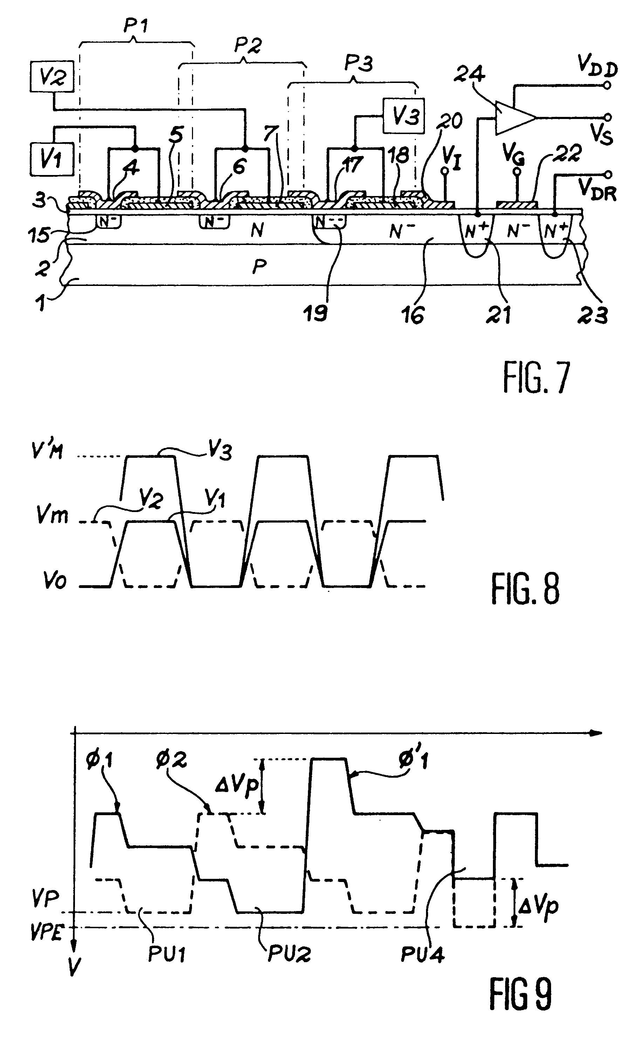

La figure 7 représente schématiquement et en coupe un dispositif conforme à l'invention comportant ici des moyens pour détecter les charges accumulées sous l'électrode de stockage 18 de la troisième paire. Les mêmes éléments portent les mêmes références sur cette figure et sur la figure 4.

Les moyens qui permettent de détecter les charges accumulées sous l'électrode de stockage 18 de la troisième paire, comprennent une électrode intermédiaire 20, adjacente à l'électrode de stockage 18 de la troisième paire et en contact avec la couche isolante 3. Ces moyens comprennent aussi une électrode de commande 22, espacée de l'électrode intermédiaire 20 et en contact avec la couche isolante 3.

Une première zone semi-conductrice 21 dopée du deuxième type avec une quatrième concentration est réalisée dans la couche semi-conductrice 16 dopée du deuxième type et d'une deuxième concentration, entre l'électrode intermédiaire 20 et l'électrode de commande 22. Une deuxième zone semi-conductrice 23 du deuxième type et de quatrième concentration est aussi réalisée dans la couche semi-conductrice 16 du second type seconde concentration, dans une portion de cette couche, adjacente à l'électrode de commande 22 dans le sens de circulation des charges.

L'électrode de commande 22, l'électrode intermédiaire 20 et la deuxième zone 23, sont respectivement reliées à des sources de tension VG, VI et VDR qui permettent de créer un puits de potentiel PU4 en regard de la première zone 21 et d'assurer le transfert dans ce puits de potentiel P3, des charges stockées sous l'électrode de stockage 18. Ce puits, comme on le verra plus loin en détail, a une profondeur moins importante que celui des puits sous les électrodes de stockage des première et deuxième paires. Cette profondeur moins importante est obtenue notamment en diminuant, grâce à la troisième paire d'électrodes et au dopage particulier de la couche semi-conductrice sous ces électrodes, les valeurs de paliers des potentiels de transfert des charges stockées sous l'électrode 18 de la troisième paire.

La première zone semi-conductrice 21 de cinquième type est reliée à un amplificateur de lecture des charges accumulées dans le puits de potentiel en regard de cette première zone. Cet amplificateur est relié à une source de tension d'alimentation V_{DD}. La valeur de cette tension d'alimentation de l'amplificateur de lecture est inférieure, grâce aux systèmes d'écluse, à la valeur de la tension d'alimentation normalement requise pour les dispositifs à transfert de charges connus dans l'état de la technique, dans lesquels il n'existe aucun moyen pour diminuer les valeurs des paliers des potentiels de transfert en regard de la dernière paire d'électrodes.

Dans un mode préféré de réalisation les zones semi-conductrices 21, 23 dopées du deuxième type et d'une quatrième concentration, sont de type N⁺.

Ces zones présentent un dopage plus important que la couche semi-conductrice dopée de deuxième type avec une première concentration N.

La figure 8 est un diagramme des tensions V1, V2, V3 appliquées respectivement aux première, deuxième et troisième paires d'électrodes. Comme dans le mode de réalisation de la figure 4, les tensions V1 et V2 sont des tensions qui varient cycliquement en opposition de phase, entre une valeur V0 et une valeur V_{M}' tandis que la tension V3 est en phase avec la tension V1 mais présente une valeur V'm plus importante que VM.

La figure 9 est un diagramme des potentiels apparaissant sous les électrodes de transfert et les électrodes de stockage du dispositif de la figure 7, ainsi que sous les électrodes intermédiaire et de commande. Ce diagramme représente également le puits de potentiel PU4, dans la première zone 21 dopée, de type N⁺. Les puits de potentiel PU1, PU2, sous les électrodes de stockage 5, 7 des première et deuxième paires sont identiques à ceux de la figure 6 et présentent la même profondeur Vₚ. Comme indiqué plus haut, dans le mode de réalisation de la figure 6, le dopage de la couche semi-conductrice 16 et la présence de la zone dopée 19 sous l'électrode de transfert 17, permettent d'abaisser les potentiels de transfert des charges stockées sous la dernière électrode de stockage 7 ; ces potentiels sont représentés en Φ'1 sur le diagramme. L'électrode intermédiaire 20 à laquelle est appliquée une tension VI permet de créer un palier de potentiel de valeur suffisante pour provoquer l'écoulement des charges stockées vers le puits de potentiel PU4 en regard de la zone 21. L'amplificateur 24 dont une entrée est reliée à cette zone fournit une tension VS proportionnelle à la quantité de charges accumulées dans le puits de potentiel PU4. En fait, grâce à la troisième paire d'électrodes P3 qui permet d'abaisser les potentiels de transfert d'une quantité ΔVP, il est possible de diminuer d'autant la tension d'alimentation V_{DD} de l'amplificateur de lecture 24. Les zones 21, 23 et l'électrode 22 reliées respectivement à l'amplificateur 24, à une source de tension VDR et à une source de tension VG, forment en fait un transistor de type MOS. L'électrode 22 est la grille de ce transistor et les zones 23 et 21 représentent respectivement le drain et la source de celui-ci. La tension appliquée à la grille VG, lorsque les charges sont stockées dans le puits de potentiel P3 permet la mesure de ces charges par l'amplificateur de lecture 24.

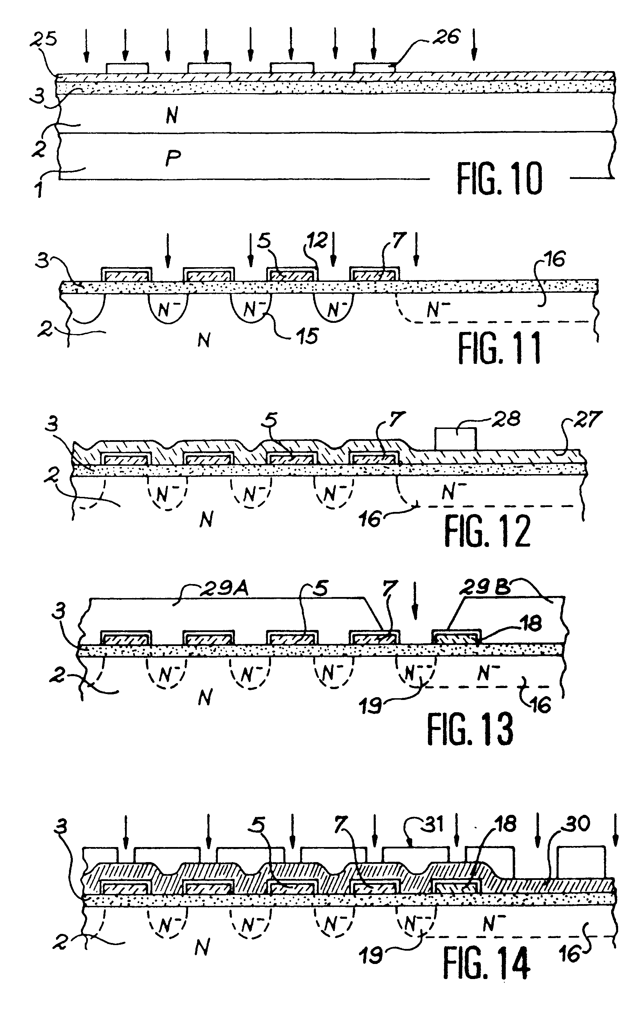

Les figures 10 à 15 représentent de manière schématique les étapes essentielles d'un premier mode de mise en oeuvre d'un procédé de fabrication d'un dispositif conforme à l'invention.

Le procédé consiste tout d'abord, tel que représenté schématiquement sur la figure 10, à former sur un substrat semi-conducteur 1 (silicium par exemple), dopé d'un premier type (de préférence de type P), une couche semi-conductrice 2 (de silicium) dopée d'un deuxième type (de préférence de type N) avec une première concentration puis à recouvrir cette couche semi-conductrice 2, d'une couche isolante 3, telle qu'un oxyde par exemple.

Le procédé consiste ensuite à former sur cette couche isolante 3 une succession d'électrodes 4, 5, 6, 7 (dont le nombre n'est évidemment pas limité à quatre) recouvertes d'un isolant 12, tel que représenté sur la figure 11. Ces électrodes sont obtenues en déposant sur la couche isolante 3, une couche 25 d'un silicium polycristallin par exemple, sur laquelle est placé un masque 26 permettant la gravure de ces électrodes, tel que représenté sur la figure 10. L'isolant qui recouvre chacune des électrodes peut être obtenu par un traitement thermique du silicium polycristallin, après gravure des électrodes.

Les électrodes 4, 5, 6, 7 sont régulièrement espacées le long d'un axe et on réalise alors (figure 11) un dopage du second type (N⁻ de préférence) avec une seconde concentration dans la couche semi-conductrice 2 de première concentration (N) entre les électrodes de la succession d'électrodes 4, 5, 6, 7. Ce dopage de second type et de seconde concentration (N⁻) est aussi réalisé au-delà de la dernière électrode 7 de la succession d'électrodes, dans la zone 16 de la couche semi-conductrice 2.

Le procédé consiste ensuite à former sur la couche isolante 3 au moins une électrode supplémentaire 18 (représentée sur la figure 13). Cette électrode supplémentaire est obtenue, comme le montre la figure 12, en déposant une couche 27 de silicium polycristallin sur les électrodes déjà réalisées et sur la couche isolante non recouverte par ces électrodes, puis à éliminer cette couche 27 de silicium polycristallin par gravure. Cette gravure est délimitée par un masque 28 qui recouvre seulement la portion de silicium polycristallin correspondant à l'électrode 18 à obtenir. Cette électrode étant obtenue, elle est recouverte d'un isolant. L'électrode 18 constitue l'électrode de stockage de la troisième paire, décrite plus haut.

On réalise ensuite, comme le montre la figure 13 un dopage de second type de la troisième concentration (N⁻⁻ de préférence) entre la dernière électrode 7 de la succession et l'électrode supplémentaire 18 dans la zone dopée 16 de deuxième concentration (N⁻). A cet effet, toutes les électrodes déjà réalisées sont recouvertes d'un masque protecteur 29A, 29B, qui est éliminé après la réalisation de la zone 19 de deuxième type et troisième concentration (N⁻⁻).

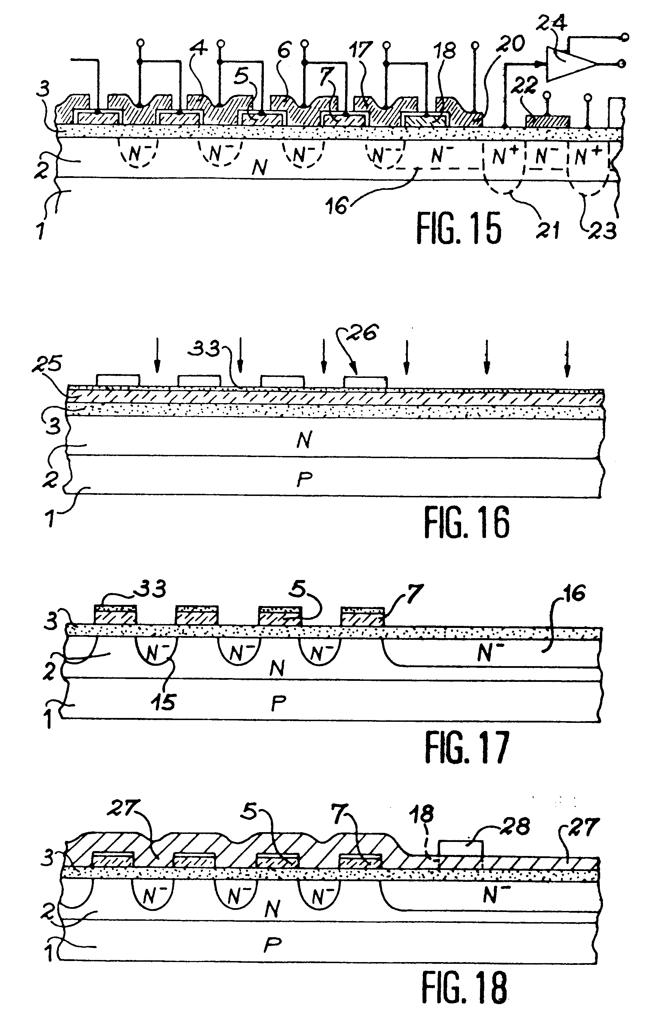

Le procédé consiste ensuite, tel que le montre la figure 15, à réaliser une série d'électrodes 4, 6, 17, 20, 22 de silicium polycristalin, situées en regard des zones dopées de deuxième type de deuxième concentration N⁻ et des zones dopées de deuxième type troisième concentration N⁻⁻. Ces électrodes sont en contact avec la couche isolante 3. Elle recouvre respectivement et partiellement les électrodes environnantes telles que 5, 7 par exemple, ainsi que les zones dopées de deuxième et troisième concentrations N⁻ et N⁻⁻. Une électrode intermédiaire 20 recouvre partiellement l'électrode supplémentaire 18.

Ce procédé consiste aussi à former sur la couche isolante 3, une électrode de commande 22 de silicium polycristallin, recouverte d'un isolant et espacée de l'électrode intermédiaire 20. Toutes ces électrodes sont obtenues comme le montre la figure 14, en recouvrant les électrodes telles que 5, 7, 18, ainsi que la couche isolante 3, d'un dépôt de silicium polycristallin 30. Ce dépôt est ensuite recouvert d'un masque 31 qui permet de graver le dépôt de silicium polycristallin 30, de manière à ne laisser subsister que les électrodes telles que 4, 6, 17, 20, 22 les électrodes déjà réalisées étant protégées par la couche isolante qui les recouvre.

On réalise ensuite un dopage d'un second type avec une quatrième concentration (de préférence de type N⁺), de part et d'autre de l'électrode de commande 22 dans la couche semi-conductrice de type N⁻. Les électrodes peuvent alors être pourvues de leurs fils de connexion permettant de les relier aux sources d'alimentation.

La zone dopée du deuxième type à la troisième concentration N⁻⁻ présente un dopage moins important que les zones dopées de second type avec la seconde concentration N⁻. La zone dopée de deuxième type et quatrième concentration (N⁺) présente au contraire un dopage plus important que la couche semi-conductrice 2 dopée de deuxième type (N).

Les figures 16 à 18 représentent schématiquement les étapes essentielles d'un autre mode de mise en oeuvre du procédé de fabrication du dispositif de l'invention. Sur ces figures, les références correspondent à celles des figures 10 à 12 précédentes. Dans ce mode de mise en oeuvre, le silicium polycristallin 25 qui est déposé sur la couche isolante 3 est préalablement à son découpage par gravure à travers un masque 26, recouvert d'un dépôt isolant 33. Ce n'est qu'ensuite que les électrodes telles que 5, 7 sont découpées comme le montre la figure 17 et que les zones semi-conductrices de troisième type (N⁻) sont implantées entre ces électrodes.

Le procédé consiste ensuite à déposer une couche 27 de silicium polycristallin qui est gravée à travers un masque de résine 28 pour former l'électrode supplémentaire 18, les électrodes précédemment gravées 5 et 7 étant protégées par le dépôt isolant 33 situé sur leurs parties supérieures. L'isolement de l'électrode 18 et des flancs des électrodes 5 et 7 est alors réalisé. La suite du processus est identique au cas précédent.

Ce mode de mise en oeuvre présente par rapport au mode de mise en oeuvre précédent l'avantage suivant : dans le mode de mise en oeuvre précédent l'oxydation de la surface des électrodes est effectuée après découpage de ces électrodes. Il en résulte que la couche isolante 3 présente une épaisseur variable puisqu'elle n'est pas protégée au cours de cette oxydation des électrodes. Dans le deuxième mode de mise en oeuvre, l'isolation de la surface des électrodes est réalisée préalablement au découpage de la couche de silicium polycristallin 25. Il en résulte qu'après découpage de ces électrodes revêtues de leur isolant la couche isolante 3 ne subit pas d'oxydation supplémentaire qui modifierait son épaisseur sous l'électrode supplémentaire 18 réalisée ultérieurement.

L'isolement latéral des électrodes 5 et 7 ainsi que l'isolement de l'électrode supplémentaire 18 sont alors réalisés.

## Revendications

1. Dispositif de transfert de charges comportant un substrat semi-conducteur (1) dopé d'un premier type, une couche semi-conductrice (2) dopée d'un deuxième type d'une première concentration recouvrant ce substrat, une couche isolante (3) recouvrant cette couche semi-conductrice et, le long d'un même axe (X) définissant un sens de circulation des charges entre une position amont et une position aval, au moins une première et une deuxième paires d'électrodes (P1, P2) comportant chacune, dans ledit sens, une électrode de transfert (4) et une électrode de stockage (5) présentant des surfaces de contact avec la couche isolante (3), des zones dopées (15) du deuxième type et d'une deuxième concentration étant réalisées, en regard des surfaces de contact des électrodes de transfert (4, 6) des première et deuxième paires (P1, P2), dans la couche semi-conductrice de deuxième type, les électrodes des première et deuxième paires étant respectivement reliées à une première et une deuxième sources de tensions (V1, V2) variant cycliquement et en opposition de phases entre une première et une deuxième valeurs (V0, VM) créant des puits de potentiel (PU1, PU2) de profondeurs égales en regard des électrodes de stockage (5, 7), et des potentiels de transfert identiques et déphasés en regard des électrodes de transfert et de stockage des première et deuxième paires, pour faire circuler les charges dans ledit sens, caractérisé en ce qu'il comporte, à partir de la position aval, le long dudit axe et dans le sens de circulation, une couche semi-conductrice (16) dopée du deuxième type et de la deuxième concentration réalisée dans la couche de deuxième type, au moins une troisième paire d'électrodes (P3) comportant, dans ledit sens, une électrode de transfert (17) et une électrode de stockage (18) présentant des surfaces de contact avec la couche isolante (3), et des moyens créant, en regard des électrodes de la troisième paire, des potentiels de transfert, de valeurs inférieures aux valeurs des potentiels de transfert en regard des électrodes de transfert et de stockage des première et deuxième paires (P1, P2).

2. Dispositif selon la revendication 1, caractérisé en ce que les moyens pour créer en regard des électrodes (18) de la troisième paire, des potentiels de transferts inférieurs à ceux des première et deuxième paires (P1, P2), comportent une zone dopée (19) du second type avec une troisième concentration, en regard de l'électrode de transfert (17) de la troisième paire, dans la couche semi-conductrice (16) dopée de second type et de seconde concentration, les électrodes de transfert et de stockage de la troisième paire étant reliées à une troisième source de tension (V3) variant cycliquement et en phase avec la tension (V1) appliquée aux électrodes de la première paire, cette tension variant entre ladite première valeur et une troisième valeur supérieure à la deuxième valeur.

3. Dispositif selon la revendication 2, caractérisé en ce que le substrat semi-conducteur (1) dopé d'un premier type, est de type P, la couche semi-conductrice (2) dopée de deuxième type d'une première concentration est de type N, la couche semi-conductrice (16) et les zones semi-conductrices (15) dopées du second type à une seconde concentration sont de type N⁻, présentant un dopage moins important que la couche semi-conductrice (2) dopée de deuxième type à la première concentration, la zone semi-conductrice (19) dopée du second type avec la troisième concentration étant de type N⁻⁻ et présentant un dopage moins important que la couche semi-conductrice dopée du second type avec la seconde concentration (N⁻).

4. Dispositif selon la revendication 2, caractérisé en ce qu'il comporte en outre des moyens pour détecter les charges accumulées sous l'électrode de stockage (18) de la troisième paire (P3), ces moyens comprenant une électrode intermédiaire (20) adjacente à l'électrode de stockage (18) de la troisième paire et en contact avec la couche isolante (3), et une électrode de commande (22) espacée de l'électrode intermédiaire (20), en contact avec la couche isolante, une zone semi-conductrice (21) dopée du second type avec une quatrième concentration réalisée dans la couche semi-conductrice (16) dopée du second type à la seconde concentration, dans une zone en regard de l'espace situé entre l'électrode intermédiaire (20) et l'électrode de commande (22), et une deuxième zone semi-conductrice (23) dopée du deuxième type avec la quatrième concentration réalisée dans la couche semi-conductrice (16) dopée de deuxième type avec la deuxième concentration, dans une zone adjacente à l'électrode de commande (22), dans le sens de circulation des charges, l'électrode de commande (22), la deuxième zone (23) et l'électrode intermédiaire (20) étant respectivement reliées à des sources de tensions pour créer un puits de potentiel (PU4) en regard de la première zone (21), de profondeur moins importante que celle du puits de potentiel sous les électrodes de stockage des première et deuxième paires, la première zone (21) étant reliée à un amplificateur (24) de mesure des charges accumulées dans le puits de potentiel en regard de cette première zone.

5. Dispositif selon la revendication 4, caractérisé en ce que les première et deuxième zones semi-conductrices dopées du deuxième type avec la quatrième concentration sont de type N⁺, présentant un dopage plus important que la couche semi-conductrice dopée de deuxième type avec la première concentration N.

6. Procédé de fabrication d'un dispositif de transfert de charges, consistant à former sur un substrat semi-conducteur (1) dopé d'un premier type, une couche semi-conductrice (2) dopée d'un deuxième type à une première concentration à recouvrir cette couche semi-conductrice d'une couche isolante (3), à former sur cette couche isolante une succession d'électrodes (5, 7) faites de silicium polycristallin et recouvertes d'un isolant, ces électrodes étant espacées le long d'un axe, puis à réaliser dans la couche semi-conductrice (2) de deuxième type, entre les électrodes de ladite succession, des zones dopées du second type avec une seconde concentration (15), une zone dopée (16) du second type avec la seconde concentration s'étendant aussi au-delà de la dernière électrode (7) de la succession, le long dudit axe, caractérisé en ce qu'il consiste en outre à former sur la couche isolante (3), au moins une électrode supplémentaire (18) de silicium polycristallin recouverte d'un isolant, espacée de la dernière électrode (7) de ladite succession, le long dudit axe, puis à réaliser une zone dopée (19) du second type avec une troisième concentration, entre la dernière électrode (7) de la succession et l'électrode supplémentaire (18), dans la zone dopée (16) du second type avec la seconde concentration, puis à réaliser une série d'électrodes (4, 6, 17) de silicium polycristallin, situées respectivement en regard des zones dopées (15, 16) à la seconde et troisième concentration, ces électrodes étant en contact avec la couche isolante (3) et recouvrant respectivement et partiellement les électrodes de ladite succession et l'électrode supplémentaire (18).

7. Procédé selon la revendication 6, caractérisé en ce qu'il consiste en outre à former sur la couche isolante (13) une électrode de commande (22) faite d'un silicium polycristallin, espacée de la dernière électrode (20) de ladite série qui recouvre partiellement ladite électrode supplémentaire (18), le long dudit axe, puis à réaliser une première et une deuxième zones (21, 23) dopées du second type avec une quatrième concentration, dans la zone semi-conductrice (16) de second type à première concentration de part et d'autre de l'électrode de commande (22).

8. Procédé selon la revendication 7, caractérisé en ce que le substrat semi-conducteur dopé d'un premier type, est de type P, la couche semi-conductrice dopée de deuxième type avec la première concentration est de type N, les zones semi-conductrices dopées du second type avec la seconde concentration sont de type N⁻, présentant un dopage moins important que la couche dopée de deuxième type avec la première concentration, les zones semi-conductrices dopées du second type avec la troisième concentration étant de type N⁻⁻, présentant un dopage moins important que les zones dopées du second type à la seconde concentration, les zones semi-conductrices dopées du second type à la quatrième concentration étant de type N⁺ présentant un dopage plus important que la couche semi-conductrice dopée de deuxième type avec la première concentration N.

## Claims

1. Charge coupled device including a doped semiconducting substrate (1) of a first type, a doped semiconducting layer (2) of a second type of a first concentration covering this substrate, an insulating layer (3) covering this semiconducting layer and, along the same axis (X) defining a direction of flow of the charges between an upstream position and a downstream position, at least one first and one second pair of electrodes (P1, P2) each including, in the said direction, a transfer electrode (4) and a storage electrode (5) having surfaces for contact with the insulating layer (3), doped zones (15) of the second type and of a second concentration being produced, facing the contact surfaces of the transfer electrodes (4, 6) of the first and second pairs (P1, P2), in the semiconducting layer of second type, the electrodes of the first and second pairs being respectively connected to a first and a second voltage source (V1, V2) varying cyclically and in phase opposition between a first and a second value (V0, VM) creating potential wells (PU1, PU2) of equal depths facing the storage electrodes (5, 7), and identical and phase-shifted transfer potentials facing the transfer and storage electrodes of the first and second pairs, in order to cause the charges to flow in the said direction, characterised in that it includes, from the downstream position, along the said axis and in the direction of flow, a doped semiconducting layer (16) of the second type and of the second concentration produced in the layer of second type, at least one third pair of electrodes (P3) including, in the said direction, a transfer electrode (17) and a storage electrode (18) having surfaces for contact with the insulating layer (3), and means creating, facing the electrodes of the third pair, transfer potentials of values less than the values of the transfer potentials facing the transfer and Storage electrodes of the first and second pairs (P1, P2).

2. Device according to Claim 1, characterised in that the means for creating, facing the electrodes (18) of the third pair, transfer potentials which are less than those of the first and second pairs (P1, P2), include a doped zone (19) of the second type with a third concentration, facing the transfer electrode (17) of the third pair, in the doped semiconducting layer (16) of second type and of second concentration, the transfer and storage electrodes of the third pair being connected to a third voltage source (V3) varying cyclically and in phase with the voltage (V1) applied to the electrodes of the first pair, this voltage varying between the said first value and a third value which is greater than the second value.

3. Device according to Claim 2, characterised in that the doped semiconducting substrate (1) of a first type is of p type, the doped semiconducting layer (2) of second type of a first concentration is of n type, the semiconducting layer (16) and the doped semiconducting zones (15) of the second type having a second concentration are of n⁻ type, having a smaller doping than the doped semiconducting layer (2) of second type having the first concentration, the doped semiconducting zone (19) of the second type with the third concentration being of n⁻⁻ type and having a smaller doping than the doped semiconducting layer of the second type with the second concentration (n⁻).

4. Device according to Claim 2, characterised in that it furthermore includes means for detecting the charges accumulated under the storage electrode (18) of the third pair (P3), these means comprising an intermediate electrode (20) adjacent to the storage electrode (18) of the third pair and in contact with the insulating layer (3), and a control electrode (22) at a certain distance away from the intermediate electrode (20), in contact with the insulating layer, a doped semiconducting zone (21) of the second type with a fourth concentration produced in the doped semiconducting layer (16) of the second type having the second concentration, in a zone facing the space located between the intermediate electrode (20) and the control electrode (22), and a second doped semiconducting zone (23) of the second type with the fourth concentration produced in the doped semiconducting layer (16) of second type with the second concentration, in a zone adjacent to the control electrode (22), in the direction of flow of the charges, the control electrode (22), the second zone (23) and the intermediate electrode (20) being respectively connected to voltage sources in order to create a potential well (PU4) facing the first zone (21), of shallower depth than that of the potential well under the storage electrodes of the first and second pairs, the first zone (21) being connected to an amplifier (24) for measuring the charges accumulated in the potential well facing this first zone.

5. Device according to Claim 4, characterised in that the first and second doped semiconducting zones of the second type with the fourth concentration are of n⁺ type, having a smaller doping than the doped semiconducting layer of second type with the first concentration n.

6. Process for manufacturing a charge coupled device, consisting in forming, on a doped semiconducting substrate (1) of a first type, a doped semiconducting layer (2) of a second type having a first concentration, in covering this semiconducting layer with an insulating layer (3), in forming, on this insulating layer, a succession of electrodes (5, 7) made from polycrystalline silicon and covered with an insulation, these electrodes being spaced apart along an axis, and then in producing, in the semiconducting layer (2) of second type, between the electrodes of the said succession, doped zones of the second type with a second concentration (15), a doped zone (16) of the second type with the second concentration also extending beyond the final electrode (7) of the succession, along the said axis, characterised in that it furthermore consists in forming, on the insulating layer (3), at least one additional electrode (18) of polycrystalline silicon covered with an insulation, at a certain distance away from the final electrode (7) of the said succession, along the said axis, then in producing a doped zone (19) of the second type with a third concentration, between the final electrode (7) of the succession and the additional electrode (18), in the doped zone (16) of the second type with the second concentration, and then in producing a series of electrodes (4, 6, 17) of polycrystalline silicon, which are located respectively facing the doped zones (15, 16) having the second and third concentrations, these electrodes being in contact with the insulating layer (3) and covering respectively and partially the electrodes of the said succession and the additional electrode (18).

7. Process according to Claim 6, characterised in that it furthermore consists in forming, on the insulating layer (13), a control electrode (22) made from a polycrystalline silicon, at a certain distance away from the final electrode (20) of the said series which partially covers the said additional electrode (18), along the said axis, and then in producing a first and a second doped zone (21, 23) of the second type with a fourth concentration, in the semiconducting zone (16) of second type having first concentration, on both sides of the control electrode (22).

8. Process according to Claim 7, characterised in that the doped semiconducting substrate of a first type is of p type, the doped semiconducting layer of second type with the first concentration is of n type, the doped semiconducting zones of the second type with the second concentration are of n⁻ type, having a smaller doping than the doped layer of second type with the first concentration, the doped semiconducting zones of the second type with the third concentration being of n⁻⁻ type, having a smaller doping than the doped zones of the second type having the second concentration, the doped semiconducting zones of the second type having the fourth concentration being of n⁺ type having a greater doping than the doped semiconducting layer of second type with the first concentration n.

## Patentansprüche

1. Ladungsverschiebungseinrichtung mit einem dotierten Halbleitersubstrat (1) eines ersten Typs, einer Halbleiterschicht (2), die von einem zweiten Typ mit einer ersten Konzentration dotiert ist und dieses Substrat bedeckt, einer Isolierschicht (3), die diese Halbleiterschicht bedeckt, und entlang derselben, einen Umlaut-Richtungssinn der Ladungen zwischen einer stromaufseitigen Position und einer stromabseitigen Position definierenden Achse (X) wenigstens einem ersten und einem zweiten Elektrodenpaar (P1, P2), die im genannten Richtungssinn jeweils eine Verschiebungselektrode (4) und eine Speicherelektrode (5) umfassen, welche Kontaktflächen mit der Isolierschicht (3) aufweisen, wobei gegenüber den Kontaktflächen der Verschiebungselektroden (4, 6) des ersten und des zweiten Paares (P1, P2) in der Halbleiterschicht des zweiten Typs Zonen (15) verwirklicht sind, die vom zweiten Typ mit einer zweiten Konzentration dotiert sind, wobei die Elektroden des ersten und des zweiten Paares mit einer ersten bzw. mit einer zweiten Spannungsquelle (V1, V2) verbunden sind, deren Spannungen sich zyklisch und gegenphasig zwischen einem ersten und einem zweiten Wert (V0, VM) ändern und gegenüber den Speicherelektroden (5, 7) Potentialtöpfe (PU1, PU2) mit gleichen Tiefen und gegenüber den Verschiebungs- und Speicherelektroden des ersten und des zweiten Paares identische und phasenverschobene Verschiebungspotentiale erzeugen, um die Ladungen im genannten Richtungssinn umlaufen zu lassen, dadurch gekennzeichnet, daß sie, beginnend bei der stromabseitigen Position entlang der genannten Achse und im Umlauf-Richtungssinn, versehen ist mit einer vom zweiten Typ mit der zweiten Konzentration dotierten und in der Schicht des zweiten Typs verwirklichten Halbleiterschicht (16), wenigstens einem dritten Elektrodenpaar (P3), das im genannten Richtungssinn eine Verschiebungselektrode (17) und eine Speicherelektrode (18) umfaßt, welche Kontaktflächen mit der Isolierschicht (3) aufweisen, und Mitteln, die gegenüber den Elektroden des dritten Paares Verschiebungspotentiale erzeugen, deren Werte kleiner sind als die Werte der Verschiebungspotentiale gegenüber den Verschiebungs- und Speicherelektroden des ersten und des zweiten Paares (P1, P2).

2. Einrichtung gemäß Anspruch 1, dadurch gekennzeichnet, daß die Mittel, die gegenüber den Elektroden (18) des dritten Paares Verschiebungspotentiale erzeugen, die Kleiner als diejenigen des ersten und des zweiten Paares (P1, P2) sind, gegenüber der Verschiebungselektrode (17) des dritten Paares in der vom zweiten Typ mit der zweiten Konzentration dotierten Halbleiterschicht (16) eine vom zweiten Typ mit einer dritten Konzentration dotierte Zone (19) aufweisen, wobei die Verschiebungs- und Speicherelektroden des dritten Paares mit einer dritten Spannungsquelle (V3) verbunden sind, deren Spannung sich zyklisch und in Phase mit der an die Elektroden des ersten Paares angelegten Spannung (V1) zwischen dem genannten ersten Wert und einem dritten Wert, der größer als der zweite Wert ist, verändert.

3. Einrichtung gemäß Anspruch 2, dadurch gekennzeichnet, daß das von einem ersten Typ dotierte Halbleitersubstrat (1) vom P-Typ ist, die vom zweiten Typ mit einer ersten Konzentration dotierte Halbleiterschicht (2) vom N-Typ ist, die Halbleiterschicht (16) und die Halbleiterzonen (15), die vom zweiten Typ mit einer zweiten Konzentration dotiert sind, vom N⁻-Typ sind und eine Dotierung aufweisen, die weniger groß als bei der vom zweiten Typ mit der ersten Konzentration dotierten Halbleiterschicht (2) ist, wobei die vom zweiten Typ mit der dritten Konzentration dotierte Halbleiterzone (19) vom N⁻⁻-Typ ist und eine Dotierung aufweist, die weniger groß als bei der vom zweiten Typ mit der zweiten Konzentration (N⁻) dotierten Halbleiterschicht ist.

4. Einrichtung gemäß Anspruch 2, dadurch gekennzeichnet, daß sie außerdem versehen ist mit Mitteln zum Erfassen der unter der Speicherelektrode (18) des dritten Paares (P3) angesammelten Ladungen, wobei diese Mittel eine an die Speicherelektrode (18) des dritten Paares angrenzende und mit der Isolierschicht (3) in Kontakt befindliche Zwischenelektrode (20) und eine von der Zwischenelektrode (20) in einem Abstand und mit der Isolierschicht in Kontakt befindliche Steuerelektrode 22 aufweisen, einer vom zweiten Typ mit einer vierten Konzentration dotierten Halbleiterzone (21), die in der vom zweiten Typ mit der zweiten Konzentration dotierten Halbleitershicht (16) in einer Zone gegenüber dem Raum zwischen der Zwischenelektrode (20) und der Steuerelektrode (22) verwirklicht ist, und einer vom zweiten Typ mit der vierten Konzentration dotierte zweiten Halbleiterzone (23), die in der vom zweiten Typ mit der zweiten Konzentration dotierten Halbleiterschicht (16) in einer im Umlauf-Richtungssinn der Ladungen an die Steuerelektrode (22) angrenzenden Zone verwirklicht ist, wobei die Steuerelektrode (22), die zweite Zone (23) und die Zwischenelektrode (20) jeweils mit Spannungsquellen verbunden sind, um gegenüber der ersten Zone (21) einen Potentialtopf (PU4) mit einer Tiefe, die weniger groß als diejenige der Potentialtöpfe unter den Speicherelektroden des ersten und des zweiten Paares ist, zu erzeugen, wobei die erste Zone (21) mit einem Verstärker (24) zum Messen der Ladungen verbunden ist, die sich im Potentialtopf gegenüber dieser ersten Zone angesammelt haben.

5. Einrichtung gemäß Anspruch 4, dadurch gekennzeichnet, daß die erste und die zweite Halbleiterzone, die vom zweiten Typ mit der vierten Konzentration dotiert sind, vom N⁺-Typ sind und eine Dotierung aufweisen, die größer als bei der vom zweiten Typ mit der zweiten Konzentration N dotierten Halbleiterschicht ist.

6. Verfahren zur Herstellung einer Ladungsverschiebungseinrichtung, das darin besteht, daß auf einem dotierten Halbleitersubstrat (1) eines ersten Typs eine von einem zweiten Typ mit einer ersten Konzentration dotierten Halbleiterschicht (2) gebildet wird, daß diese Halbleiterschicht mit einer Isolierschicht (3) bedeckt wird, daß auf dieser Isolierschicht eine Folge von aus polykristallinem Silizium hergestellten und mit einem Isolator abgedeckten Elektroden (5, 7) gebildet wird, die sich entlang einer Achse in Abständen befinden, daß dann in der Halbleiterschicht (2) des zweiten Typs zwischen den Elektroden der genannten Folge vom zweiten Typ mit einer zweiten Konzentration dotierte Zonen (15) verwirklicht werden, wobei sich eine vom zweiten Typ mit der zweiten Konzentration dotierte Zone (16) entlang der Achse auch über die letzte Elektrode (7) der Folge hinaus erstreckt, dadurch gekennzeichnet, daß es außerdem darin besteht, daß auf der Isolierschicht (3) wenigstens eine zusätzliche Elektrode (18) aus polykristallinem Silizium gebildet wird, die mit einem Isolator bedeckt ist und sich von der letzten Elektrode (7) der Folge entlang der Achse in einem Abstand befindet, daß dann eine vom zweiten Typ mit einer dritten Konzentration dotierte Zone (19) zwischen der letzten Elektrode (7) der Folge und der zusätzlichen Elektrode (18) in der vom zweiten Typ mit der zweiten Konzentration dotierten Zone (16) gebildet wird, daß dann eine Reihe von Elektroden (4, 6, 17) aus polykristallinem Silizium gebildet werden, die sich jeweils gegenüber den mit der zweiten bzw. mit der dritten Konzentration dotierten Zonen (15, 16) befinden, wobei diese Elektroden mit der Isolierschicht (3) in Kontakt sind und die Elektroden der genannten Folge bzw. die zusätzliche Elektrode (18) teilweise abdecken.

7. Verfahren gemäß Anspruch 6, dadurch gekennzeichnet, daß es außerdem darin besteht, daß auf der Isolierschicht (13) eine aus polykristallinem Silizium hergestellte Steuerelektrode (22) gebildet wird, die sich von der letzten Elektrode (20) der die zusätzliche Elektrode (18) teilweise abdeckenden Reihe entlang der Achse in einem Abstand befindet, und daß dann eine erste und eine zweite, vom zweiten Typ mit einer vierten Konzentration dotierte Zone (21, 23) in der Halbleiterzone (16) des zweiten Typs mit der ersten Konzentration beiderseits der Steuerelektrode (22) gebildet werden.

8. Verfahren gemäß Anspruch 7, dadurch gekennzeichnet, daß das von einem ersten Typ dotierte Halbleitersubstrat vom P-Typ ist, daß die vom zweiten Typ mit der ersten Konzentration dotierte Halbleiterschicht vom N-Typ ist, die vom zweiten Typ mit der zweiten Konzentration dotierten Halbleiterzonen vom N⁻-Typ sind und eine Dotierung aufweisen, die weniger groß als bei der vom zweiten Typ mit der ersten Konzentration dotierten Schicht ist, daß die vom zweiten Typ mit der dritten Konzentration dotierten Halbleiterzonen vom N⁻⁻-Typ sind und eine Dotierung aufweisen, die weniger groß als bei den vom zweiten Typ mit der zweiten Konzentration dotierten Zonen ist, und daß die vom zweiten Typ mit der vierten Konzentration dotierten Halbleiterzonen vom N⁺-Typ sind und eine Dotierung aufweisen, die größer als bei der vom zweiten Typ mit der ersten Konzentration N dotierten Halbleiterschicht ist.
